# EUROPEAN PATENT APPLICATION

(11) **EP 4 325 574 A1**
(43) Date of publication of application: **21.02.2024**
(21) Application number: 23190855.9
(22) Date of filing: 10.08.2023
(51) Int. Cl.: H01L 27/146

(54) **IMAGE SENSOR HAVING NANO-PHOTONIC LENS ARRAY AND ELECTRONIC APPARATUS INCLUDING THE SAME**

(30) Priority: 19.08.2022 KR 20220104270
(71) Applicant: Samsung Electronics Co., Ltd., Suwon-si, Gyeonggi-do 16677 (KR)
(72) Inventor: YUN, Seokho, 16678, Suwon-si, (KR); ROH, Sookyoung, 16678, Suwon-si, (KR); MUN, Sangeun, 16678, Suwon-si, (KR); PARK, Hyunsung, 16678, Suwon-si, (KR); AHN, Sungmo, 16678, Suwon-si, (KR); LEE, Sangyun, 16678, Suwon-si, (KR); LEE, Junho, 16678, Suwon-si, (KR); CHO, Choonlae, 16678, Suwon-si, (KR)
(74) Representative: Elkington and Fife LLP

(57) **Abstract**

An image sensor includes a sensor substrate including a plurality of first pixels for sensing light of a first wavelength band and a plurality of second pixels for sensing light of a second wavelength band that is different from the first wavelength band, a color filter layer on the sensor substrate, and including a plurality of color filters , a planarization layer arranged on the color filter layer, an encapsulation layer arranged on the planarization layer, and a nano-photonic lens array arranged on the encapsulation layer, and including a plurality of nano-structures that are arranged to condense incident light onto the plurality of first pixels and the plurality of second pixels.

## Description

### FIELD OF THE INVENTION

One or more embodiments relate to an image sensor including a nano-photonic lens array and an electronic apparatus including the same.

### BACKGROUND OF THE INVENTION

Image sensors generally sense the color of incident light by using a color filter. However, a color filter may have low light utilization efficiency because the color filter absorbs light of colors other than an intended color. For example, when a red-green-blue (RGB) color filter is used, only 1/3 of the incident light is transmitted therethrough. The remaining portion of the incident light, that is, 2/3 of the incident light, is absorbed. Thus, light utilization efficiency is only about 33%. In a color display apparatus or a color image sensor, most light loss occurs in the color filter.

### SUMMARY OF THE INVENTION

Apparatus consistent with this disclosure include an image sensor including a nano-photonic lens array.

Additional aspects will be set forth in part in the description which follows. Additional aspects will be apparent to one skilled in the art based on the description, or may be learned by practice of disclosed example embodiments.

An example embodiment of an image sensor may include: a sensor substrate including a plurality of first pixels for sensing light of a first wavelength band and a plurality of second pixels for sensing light of a second wavelength band that is different from the first wavelength band; a color filter layer on the sensor substrate, the color filter layer including a plurality of color filters ; a planarization layer arranged on the color filter layer; an encapsulation layer arranged on the planarization layer; and a nano-photonic lens array arranged on the encapsulation layer, the nano-photonic lens array including a plurality of nano-structures that are arranged to condense incident light onto the plurality of first pixels and the plurality of second pixels.

An example embodiment may have the plurality of color filters in the color filter layer include organic color filters including an organic dye or an organic pigment.

An example embodiment may include the planarization layer having an organic polymer material.

An example embodiment may include the organic polymer material including at least one from an epoxy resin, polyimide, polycarbonate, polyacrylate, and polymethyl methacrylate.

An example embodiment may include the encapsulation layer including an inorganic material.

An example embodiment may include the inorganic material including at least one from SiO₂, SiN, and SiON.

An example embodiment may include a difference between a refractive index of the planarization layer and a refractive index of the encapsulation layer is within ±20% of the refractive index of the planarization layer.

An example embodiment may have a thickness of the encapsulation layer less than a thickness of the planarization layer.

An example embodiment may include a thickness of the encapsulation layer is about 100 nm to about 500 nm.

An example embodiment may include the planarization layer has a thickness of about 300 nm to about 5 µm.

An example embodiment may include a difference between a sum of a thickness of the color filter layer, a thickness of the planarization layer, and a thickness of the encapsulation layer and a focal length of the nano-photonic lens array is within ±20% of the focal length of the nano-photonic lens array.

An example embodiment may include a sum of a thickness of the planarization layer and a thickness of the encapsulation layer is equal to or greater than a thickness of the nano-photonic lens array.

An example embodiment may include each of the plurality of first pixels and second pixels including: a plurality of photosensitive cells that are two-dimensionally arranged and grouped in a first direction and a second direction and independently sense light, the second direction being perpendicular to the first direction; and an isolation electrically isolating the plurality of photosensitive cells.

An example embodiment may include an etch stop layer arranged between the encapsulation layer and the nano-photonic lens array.

An example embodiment may include the nano-photonic lens array having a first pattern of nano structures corresponding to a respective first pixel of the plurality of first pixels, and a second pattern of nano structures corresponding to a respective second pixel of the plurality of second pixels, wherein the first pattern of nano structures and the second pattern of nano structures are disposed next to each other, and wherein the first pattern of nano structures and the second pattern of nano structures condense the incident light onto the respective first pixel of the plurality of pixels.

An example embodiment of an image sensor may include a sensor substrate including a plurality of first pixels for sensing light of a first wavelength band and a plurality of second pixels for sensing light of a second wavelength band that is different from the first wavelength band; a color filter layer on the sensor substrate, the color filter layer including a plurality of color filters; a transparent encapsulation layer arranged on the color filter layer; and a nano-photonic lens array arranged on the encapsulation layer, the nano-photonic lens array including a plurality of nano-structures that are arranged to condense incident light onto the plurality of first pixels and the plurality of second pixels.

An example embodiment may include the encapsulation layer including an inorganic material.

An example embodiment may include the encapsulation layer only includes the inorganic material.

An example embodiment may include the encapsulation layer is in contact with the color filter layer.

An example embodiment may include an etch stop layer arranged between the nano-photonic lens array and the encapsulation layer.

An example embodiment of an electronic apparatus may include: a lens assembly for forming an optical image of a subject; an image sensor for converting the optical image formed by the lens assembly into an electrical signal; and a processor configured to process a signal generated by the image sensor, wherein the image sensor comprises: a sensor substrate including a plurality of pixels sensing light; a color filter layer on the sensor substrate, the color filter layer including a plurality of color filters ; a transparent planarization layer arranged on the color filter layer; a transparent encapsulation layer arranged on the planarization layer; and a nano-photonic lens array arranged on the encapsulation layer and including a plurality of nano-structures arranged to condense incident light onto the plurality of pixels.

### BRIEF DESCRIPTION OF THE DRAWINGS

The above and other aspects, features, and advantages of example embodiments of the disclosure will be more apparent from the following description taken in conjunction with the accompanying drawings, in which:
FIG. 1 is a block diagram of an image sensor according to an embodiment;
FIGS. 2A to 2C are diagrams showing examples of various pixel arrangements in a pixel array of an image sensor;
FIGS. 3A and 3B are cross-sectional views schematically showing a structure of a pixel array in an image sensor according to an embodiment;
FIG. 4 is a plan view schematically showing a structure of a sensor substrate in a pixel array of FIGS. 3A and 3B;
FIG. 5 is a plan view schematically showing a structure of a color filter layer of FIGS. 3A and 3B;
FIG. 6 is a plan view showing an example of a nano-photonic lens array of FIGS. 3A and 3B;
FIG. 7 is a diagram showing an example of phase profiles of green light and blue light after passing through the nano-photonic lens array of FIG. 6;
FIG. 8 is a diagram showing an example of passage of green light incident on a periphery of a first lens in a nano-photonic lens array;
FIG. 9 is a diagram showing an example of an array of a first green light condensing region formed by a nano-photonic lens array;
FIG. 10 is a diagram showing an example of passage of blue light that is incident on a periphery of a second lens in a nano-photonic lens array;
FIG. 11 is a diagram showing an example of an array of a blue light condensing region formed by a nano-photonic lens array;
FIG. 12 is a diagram showing an example of phase profiles of red light and green light after passing through the nano-photonic lens array of FIG. 6;
FIG. 13 is a diagram showing an example of passage of red light that is incident on a periphery of a third lens in a nano-photonic lens array;
FIG. 14 is a diagram showing an example of an array of a red light condensing region formed by a nano-photonic lens array;
FIG. 15 is a diagram showing an example of passage of green light that is incident on a periphery of a fourth lens in a nano-photonic lens array;
FIG. 16 is a diagram showing an example of an array of a second green light condensing region formed by a nano-photonic lens array;
FIG. 17 is a plan view showing examples of arrangements of nano-structures in a nano-photonic lens array according to another example embodiment in detail;
FIGS. 18A and 18B are diagrams showing an example of a phase profile of red light and green light after passing through the nano-photonic lens array of FIG. 17;
FIG. 19 is a cross-sectional view schematically showing a structure of a pixel array in an image sensor according to another example embodiment;
FIG. 20 is a cross-sectional view schematically showing a structure of a pixel array in an image sensor according to another example embodiment;
FIG. 21 is a block diagram of an electronic device including an image sensor according to an example embodiment; and
FIG. 22 is a block diagram schematically showing a camera module in FIG. 21.

### DETAILED DESCRIPTION

Reference will now be made in detail to embodiments, examples of which are illustrated in the accompanying drawings, wherein like reference numerals refer to like elements throughout. In this regard, the example embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, an image sensor including a nano-photonic lens array and an electronic apparatus including the image sensor will be described in detail with reference to accompanying drawings. Example embodiments of the disclosure are capable of various modifications and may be embodied in many different forms. In the drawings, sizes of components in the drawings may be exaggerated to facilitate explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not necessarily indicated that materials or structures of components are different from one another.

An expression used in the singular encompasses the expression of the plural, unless it has a clearly different meaning in the context. It will be further understood that when a portion is referred to as "comprises" another component, the portion may not exclude another component but may further comprise another component unless the context indicates otherwise.

In addition, the terms such as "... unit", "module", etc. provided herein indicates a unit performing a function or operation, and may be realized by hardware (such as one or more processors), software, or a combination of hardware and software.

The use of the terms of "the above-described" and similar indicative terms may correspond to both the singular form and the plural form.

Also, the steps of all methods described herein may be performed in any suitable order unless otherwise indicated herein or otherwise clearly contradicted by context. Also, the use of all exemplary terms (for example, etc.) is only to describe a technical detail, and the scope of rights is not limited by these terms.

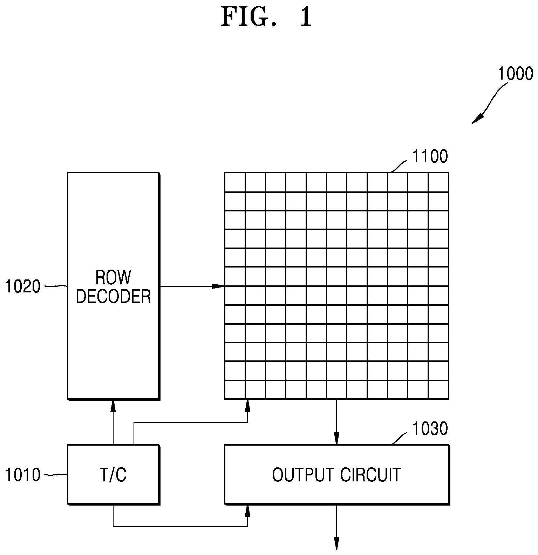

FIG. 1 is a schematic block diagram of an image sensor 1000 according to an embodiment. Referring to FIG. 1, the image sensor 1000 may include a pixel array 1100, a timing controller 1010, a row decoder 1020, and an output circuit 1030. The image sensor 1000 may include a charge-coupled device (CCD) image sensor or a complementary metal oxide semiconductor (CMOS) image sensor.

The pixel array 1100 includes pixels that are two-dimensionally arranged in a plurality of rows and columns. The row decoder 1020 selects one of the rows in the pixel array 1100 in response to a row address signal output from the timing controller 1010. The output circuit 1030 outputs a signal representative of detected light, for example, in a column unit, from a plurality of pixels arranged in the selected row. To this end, the output circuit 1030 may include a column decoder and an analog-to-digital converter (ADC). For example, the output circuit 1030 may include a plurality of ADCs that are arranged respectively for a plural columns. The ADCs may be arranged between the column decoder and the pixel array 1100, or one ADC may be arranged at an output end of the column decoder. The timing controller 1010, the row decoder 1020, and the output circuit 1030 may be implemented as one chip or separate chips. A processor for processing an image signal output from the output circuit 1030 may be implemented as one chip along with the timing controller 1010, the row decoder 1020, and the output circuit 1030.

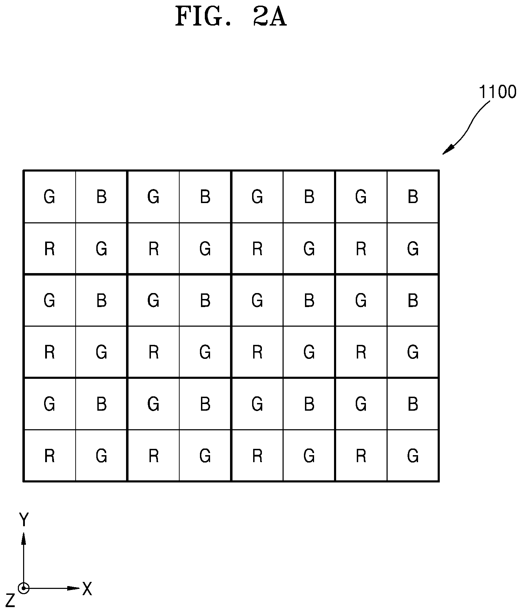

The pixel array 1100 may include a plurality of pixels that sense light of different wavelength bands. The pixel arrangement may be implemented in various ways. For example, FIGS. 2A to 2C show various pixel arrangements in the pixel array 1100 of the image sensor 1000.

FIG. 2A shows a Bayer pattern for an image sensor 1000. Referring to FIG. 2A, one unit pattern includes four quadrant regions. First to fourth quadrant regions may correspond respectively to a blue pixel B, a green pixel G, a red pixel R, and a green pixel G. The unit patterns may be repeatedly and two-dimensionally arranged in a first direction (X direction) and a second direction (Y direction). For example, two green pixels G are arranged in one diagonal direction and one blue pixel B and one red pixel R are arranged in another diagonal direction in a unit pattern of a 2×2 array. In the entire arrangement of pixels, a first row in which a plurality of green pixels G and a plurality of blue pixels B are alternately arranged in the first direction and a second row in which a plurality of red pixels R and a plurality of green pixels G are alternately arranged in the first direction. The first and second rows are repeatedly arranged in a second direction.

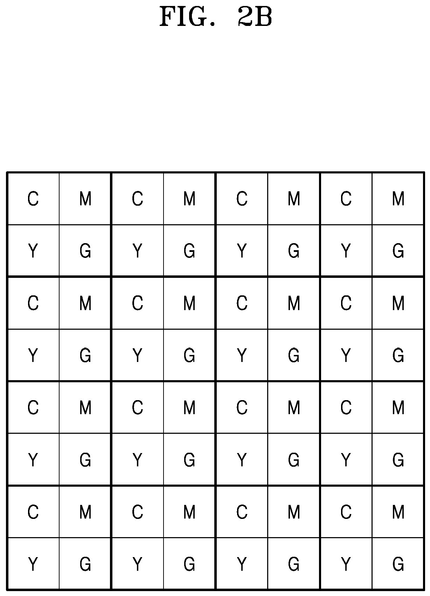

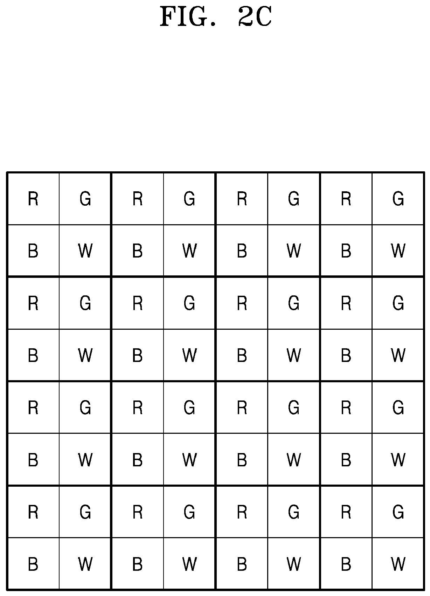

The pixel array 1100 may be arranged in various arrangement patterns, other than the Bayer pattern. For example, referring to FIG. 2B, a CYGM arrangement, in which a magenta pixel M, a cyan pixel C, a yellow pixel Y, and a green pixel G form one unit pattern, may be used. Also, referring to FIG. 2C, an RGBW arrangement, in which a green pixel G, a red pixel R, a blue pixel, and a white pixel W form one unit pattern, may be used. The unit pattern may alternately have a 3×2 array form. In addition to the above examples, the pixels in the pixel array 1100 may be arranged in various ways according to color characteristics of the image sensor 1000. Hereinafter, it will be described that the pixel array 1100 of the image sensor 1000 has a Bayer pattern, but the operating principles may be applied to patterns of pixel arrangement other than the Bayer pattern.

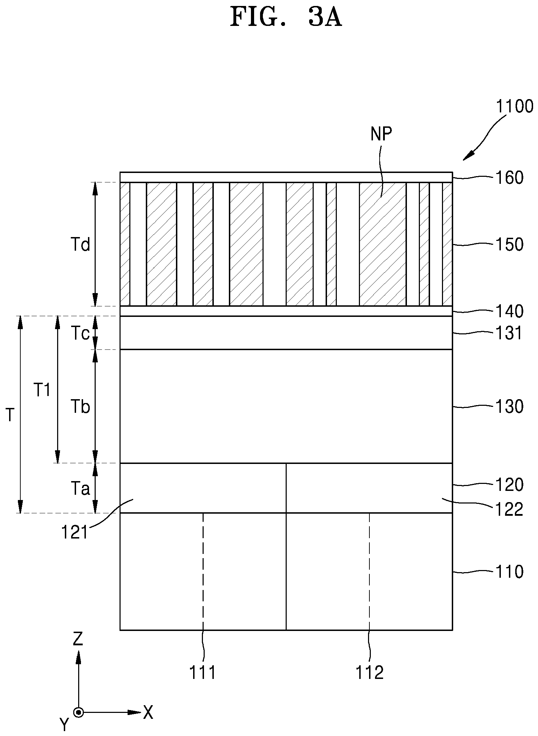

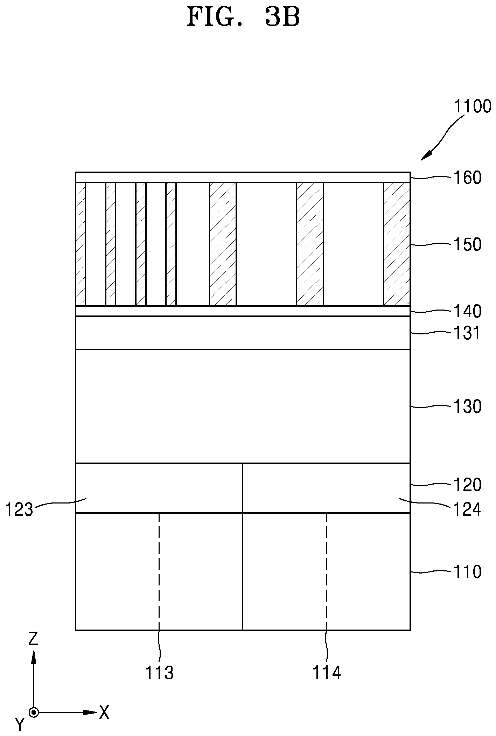

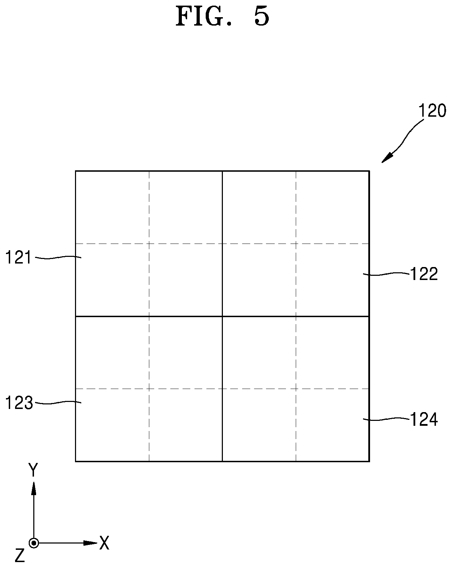

FIGS. 3A and 3B are cross-sectional views schematically showing a structure of a pixel array 1100 in an image sensor according to an embodiment. FIG. 3A shows a cross-section of the pixel array 1100 taken along the first direction (X-direction) having first row filter elements 121, 122, and FIG. 3B shows a cross-section of the pixel array 1100, taken along the first direction (X-direction) and different from the cross-section of FIG. 3A having second row filter elements 123, 124. See, for example Fig. 5.

Referring to FIGS. 3A and 3B, the pixel array 1100 may include a sensor substrate 110, a color filter layer 120 arranged on the sensor substrate 110, a planarization layer 130 that is transparent and arranged on the color filter layer 120, an encapsulation layer 131 that is transparent and arranged on the planarization layer 130, and a nano-photonic lens array 150 arranged on the encapsulation layer 131. Also, the pixel array 1100 may further include an etch stop layer 140 between the encapsulation layer 131 and the nano-photonic lens array 150. Also, the pixel array 1100 may further include an anti-reflection layer 160 arranged on a light incident surface of the nano-photonic lens array 150. The etch stop layer 140 and the anti-reflection layer 160 may be omitted.

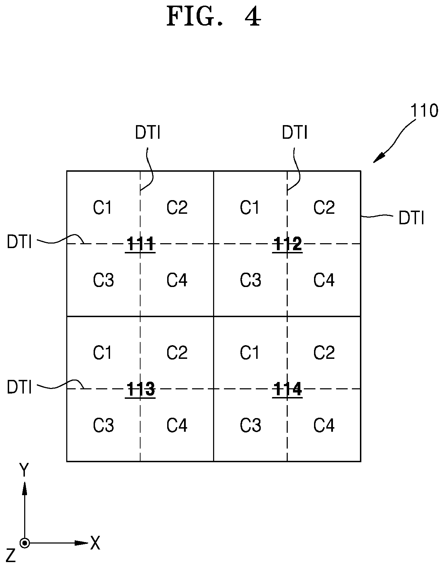

FIG. 4 is a plan view schematically showing a structure of the sensor substrate 110 in the pixel array 1100 of FIGS. 3A and 3B. Referring to FIG. 4, the sensor substrate 110 may include a plurality of pixels sensing incident light. For example, the sensor substrate 110 may include a first pixel 111, a second pixel 112, a third pixel 113, and a fourth pixel 114 that convert incident light into electrical signals and generate an image signal. The first pixel 111, the second pixel 112, the third pixel 113, and the fourth pixel 114 may form one unit Bayer pattern. For example, the first and fourth pixels 111 and 114 may be green pixels sensing green light, the second pixel 112 may be a blue pixel sensing blue light, and the third pixel 113 may be a red pixel sensing red light.

FIGS. 3A, 3B, and 4 only show one unit Bayer pattern including four pixels as an example, but the pixel array 1100 may include a plurality of Bayer patterns that are two-dimensionally arranged. For example, a plurality of first pixels 111 and a plurality of second pixels 112 may be alternately arranged in a first direction (X-direction), and a plurality of third pixels 113 and a plurality of fourth pixels 114 may be alternately arranged in the first direction (X-direction) on a cross-section located differently in a second direction (Y-direction) perpendicular to the first direction (X-direction).

Each of the first to fourth pixels 111, 112, 113, and 114 may include a plurality of photosensitive cells that independently sense incident light. For example, each of the first to fourth pixels 111, 112, 113, and 114 may include first to fourth photosensitive cells C1, C2, C3, and C4. The first to fourth photosensitive cells C1, C2, C3, and C4 may be two-dimensionally arranged in the first direction (X-direction) and the second direction (Y-direction). For example, in each of the first to fourth pixels 111, 112, 113, and 114, the first to fourth photosensitive cells C1, C2, C3, and C4 may be arranged in a 2x2 array.

FIG. 4 shows an example in which each of the first to fourth pixels 111, 112, 113, and 114 includes four photosensitive cells, but four or more independent photosensitive cells may be grouped and two-dimensionally arranged. For example, each of the first to fourth pixels 111, 112, 113, and 114 may include a plurality of independent photosensitive cells that are grouped and arranged in a 3x3 array or 4x4 array. Hereinafter, an example in which each of the first to fourth pixels 111, 112, 113, and 114 includes the photosensitive cells arranged in a 2x2 array will be described for convenience of description.

According to the embodiment, an auto-focusing signal may be obtained from a difference between output signals of adjacent photosensitive cells. For example, an auto-focusing signal in the first direction (X-direction) may be generated from a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, an auto-focusing signal in the second direction (Y-direction) may be generated from a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

In addition, a general image signal may be obtained by summing output signals from the first to fourth photosensitive cells C1, C2, C3, and C4. For example, a first green image signal may be generated by summing the output signals from the first to fourth photosensitive cells C1, C2, C3, and C4 of the first pixel 111, a blue image signal may be generated by summing the output signals from the first to fourth photosensitive cells C1, C2, C3, and C4 of the second pixel 112, a red image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114.

Also, each of the first to fourth pixels 111, 112, 113, and 114 may include deep trench isolation (DTI) structure that electrically isolates the plurality of photosensitive cells from one another. The DTI structure may be filled with air or an electrically insulating material. The DTI may extend in the first direction (X-direction) and the second direction (Y-direction) so as to divide each of the first to fourth pixels 111, 112, 113, and 114 into four. The first to fourth photosensitive cells C1, C2, C3, and C4 in each of the first to fourth pixels 111, 112, 113, and 114 may be isolated from one another by the isolation DTI. The isolation DTI extending in the first direction (X-direction) and the isolation DTI extending in the second direction (Y-direction) may cross each other at the center of each of the first to fourth pixels 111, 112, 113, and 114.

Also, the isolation DTI may be arranged in the first direction (X-direction) and the second direction (Y-direction) between adjacent pixels from among the first to fourth pixels 111, 112, 113, and 114. Therefore, the first to fourth pixels 111, 112, 113, and 114 may be isolated from one another due to the isolation DTI. The isolation DTI extending in the first direction (X-direction) and the isolation DTI extending in the second direction (Y-direction) may cross each other at the center of the unit Bayer pattern including the first to fourth pixels 111, 112, 113, and 114.

FIG. 5 is a plan view schematically showing a structure of the color filter layer 120 of FIGS. 3A and 3B. Referring to FIG. 5, the color filter layer 120 may include a plurality of color filters each transmitting light of a certain wavelength band and absorbing light of another wavelength band. For example, the color filter layer 120 may include a first color filter 121 transmitting light of a first wavelength band and absorbing light of another wavelength band, a second color filter 122 transmitting light of a second wavelength band that is different from the first wavelength band and absorbing light of another wavelength band, a third color filter 123 transmitting light of a third wavelength band that is different from the first and second wavelength bands and absorbing light of another wavelength band, and a fourth color filter 124 transmitting light of the first wavelength band and absorbing light of another wavelength band. FIG. 5 only shows one unit Bayer pattern, but a plurality of first color filters 121 and a plurality of second color filters 122 may be alternately arranged in the first direction (X-direction), and a plurality of third color filters 123 and a plurality of fourth color filters 124 may be alternately arranged in the first direction (X-direction) The two filter patterns may be arranged in the second direction (Y-direction) that is perpendicular to the first direction (X-direction).

The first color filter 121 may be arranged to face the first pixel 111 in a third direction (Z-direction), the second color filter 122 may be arranged to face the second pixel 112 in the third direction (Z-direction), the third color filter 123 may be arranged to face the third pixel 113 in the third direction (Z-direction), and the fourth color filter 124 may be arranged to face the fourth pixel 114 in the third direction (Z-direction). Accordingly, the first pixel 111 and the fourth pixel 114 may sense the light of the first wavelength band that has passed through the first color filter 121 and the fourth color filter 124 respectively corresponding thereto. Also, the second pixel 112 may sense the light of the second wavelength band that has passed through the second color filter 122 corresponding thereto. The third pixel 113 may sense the light of the third wavelength band that has passed through the third color filter 123 corresponding thereto. For example, the first color filter 121 and the fourth color filter 124 may be green color filters transmitting the green light, the second color filter 122 may be a blue color filter transmitting the blue light, and the third color filter 123 may be a red color filter transmitting the red light.

Dashed lines shown in FIG. 5 indicate the isolation between the photosensitive cells in the first to fourth pixels 111, 112, 113, and 114. As shown in FIG. 5, the first to fourth color filters 121, 122, 123, and 124 may be arranged to face the photosensitive cells in the first to fourth pixels 111, 112, 113, and 114 respectively corresponding thereto in the third direction (Z-direction). In other words, the first color filter 121 covers all photosensitive cells in the first pixel 111, the second color filter 122 covers all photosensitive cells in the second pixel 112, the third color filter 123 covers all photosensitive cells in the third pixel 113, and the fourth color filter 124 covers all photosensitive cells in the fourth pixel 114.

The first to fourth color filters 121, 122, 123, and 124 in the color filter layer 120 may be formed of, for example, an organic polymer material. For example, the first to fourth color filters 121, 122, 123, and 124 may include a coloring agent, binder resin, polymer photoresist, etc. The first and fourth color filters 121 and 124 may be organic color filters including green organic dye or a green organic pigment as a coloring agent, the second color filter 122 may be an organic color filter including a blue organic dye or a blue organic pigment as a coloring agent, and the third color filter 123 may be an organic color filter including a red organic dye or a red organic pigment as a coloring agent. The color filter layer 120 may further include a black matrix arranged at boundaries between the first to fourth color filters 121, 122, 123, and 124. The black matrix may include, for example, carbon black.

In FIGS. 3A and 3B, although the color filter layer 120 is shown to have a flat upper surface, the upper surface of each of the first to fourth color filters 121, 122, 123, and 124 may not be flat. Also, thicknesses of the first to fourth color filters 121, 122, 123, and 124 and the black matrix may not be identical to each other. The planarization layer 130 on the color filter layer 120 may provide a flat surface for forming the nano-photonic lens array 150 thereon. The planarization layer 130 may include an organic polymer material that is suitable for being stacked on the color filter layer 120 that is formed of an organic material and may easily form a flat surface. The organic polymer material forming the planarization layer 130 may be transparent with respect to visible light. For example, the planarization layer 130 may include at least one organic polymer material from an epoxy resin, polyimide, polycarbonate, polyacrylate, and polymethyl methacrylate (PMMA). The planarization layer 130 may be formed on the color filter layer 120 by, for example, a spin coating method, and may have a flat upper surface through a thermal treatment.

An encapsulation layer 131 may be further arranged on the planarization layer 130. The encapsulation layer 131 may function as a protective layer for preventing the planarization layer 130 formed of an organic polymer material from being damaged during a process of forming the nano-photonic lens array 150 on the planarization layer 130. Also, the encapsulation layer 131 may function as a diffusion barrier layer that prevents a metal component in the color filter layer 120 from passing through the planarization layer 130 and being exposed to outside due to the high temperature during the process of forming the nano-photonic lens array 150. To this end, the encapsulation layer 131 may include an inorganic material. The inorganic material of the encapsulation layer 131 may be formed at a temperature lower than a processing temperature for forming the nano-photonic lens array 150 and may include a material transparent with respect to visible light. Also, a refractive index of the encapsulation layer 131 may be similar to that of the planarization layer 130 in order to reduce reflection loss at an interface between the planarization layer 130 and the encapsulation layer 131. For example, a difference between the refractive index of the planarization layer 130 and the refractive index of the encapsulation layer 131 may be within ±20% of the refractive index of the planarization layer 130. For example, the encapsulation layer 131 may include at least one inorganic material selected from SiO₂, SiN, and SiON.

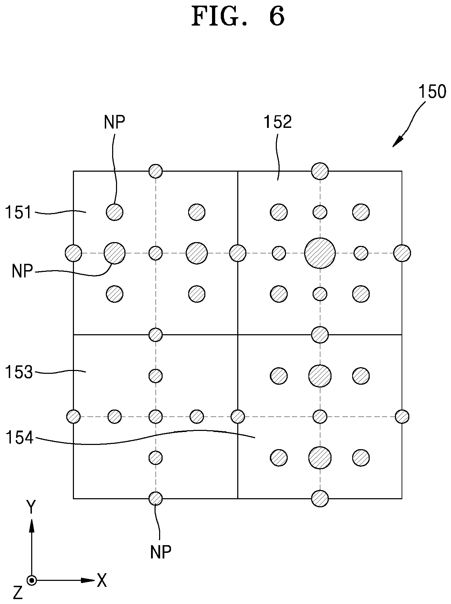

FIG. 6 is a plan view showing an example of the nano-photonic lens array 150 of FIGS. 3A and 3B. Referring to FIG. 6, the nano-photonic lens array 150 may include a first lens 151 corresponding to the first pixel 111, a second lens 152 corresponding to the second pixel 112, a third lens 153 corresponding to the third pixel 113, and a fourth lens 154 corresponding to the fourth pixel 114. For example, the first lens 151 may be arranged to face the first pixel 111 in the third direction (Z-direction), the second lens 152 may be arranged to face the second pixel 112 in the third direction (Z-direction), the third lens 153 may be arranged to face the third pixel 113 in the third direction (Z-direction), and the fourth lens 154 may be arranged to face the fourth pixel 114 in the third direction (Z-direction). FIG. 6 only shows one unit Bayer pattern as an example, but a plurality of first lenses 151 and a plurality of second lenses 152 may be alternately arranged in the first direction (X-direction), and a plurality of third lenses 153 and a plurality of fourth lenses 154 may be alternately arranged in the first direction (X-direction). The pattern of first lenses 151, 152 and the pattern of second lenses 153, 154 may be arranged in a second direction (Y-direction) that is perpendicular to the first direction (X-direction).

The nano-photonic lens array 150 may include a plurality of nano-structures NP that are arranged to condense incident light respectively to the first to fourth pixels 111, 112, 113, and 114. The plurality of nano-structures NP may be arranged so that a phase of light transmitting through the nano-photonic lens array 150 is changed according to a position on the nano-photonic lens array 150. A phase profile of the transmitted light, which is implemented by the nano-photonic lens array 150, may be determined according to a width (or diameter) and a height of each of the nano-structures NP, and the arrangement period (or pitch) and arrangement type of the plurality of nano-structures NP. Also, the behavior of the light passing through the nano-photonic lens array 150 may be determined according to the phase profile of the transmitted light. For example, the plurality of nano-structures NP may be arranged so as to form a phase profile allowing the light transmitted through the nano-photonic lens array 150 to condense.

The nano-structures NP may have a size that is less than a wavelength of visible light. The nano-structures NP may have, for example, a size that is less than the blue wavelength. For example, the cross-sectional width (or diameter) of the nano-structures NP may be less than 400 nm, 300 nm, or 200 nm. A height of the nano-structures NP may be about 500 nm to about 1500 nm, and may be greater than the cross-sectional width of the nano-structures NP.

The nano-structures NP may include a material having a relatively higher refractive index as compared with a peripheral material and having a relatively lower absorbent ratio in the visible ray band. For example, the nano-structures NP may include c-Si (crystalline Si), p-Si (polycrystalline Si), a-Si (amorphous Si) and a Group III-V compound semiconductor (GaP, GaN, GaAs etc.), SiC, TiO₂, SiN₃, ZnS, ZnSe, Si₃N₄, and/or a combination thereof. The periphery of the nano-structures NP may be filled with a dielectric material having a relatively lower refractive index as compared with the nano-structures NP and a relatively low absorbent ratio in the visible ray band. For example, the periphery of the nano-structures NP may be filled with siloxane-based spin on glass (SOG), SiO₂, Si₃N₄, Al₂O₃, air, etc.

The refractive index of the nano-structures NP may be about 2.0 or greater with respect to light of about a 630 nm wavelength, and the refractive index of a peripheral material may be about 1.0 to about 2.0 or less with respect to light of about a 630 nm wavelength. Also, a difference between the refractive index of the nano-structures NP and the refractive index of the peripheral material may be about 0.5 or greater. The nano-structures NP having a difference in a refractive index from the refractive index of the peripheral material may change the phase of light that passes through the nano-structures NP. This is caused by phase delay that occurs due to the shape dimension of the sub wavelength of the nanostructures NP, and a degree at which the phase is delayed may be determined by a detailed shape dimension and arrangement shape of the nanostructures NP.

In an example, the nano-photonic lens array 150 may condense light of the first wavelength band, in the incident light, to the first pixel 111 and the fourth pixel 114, condense light of the second wavelength band to the second pixel 112, and condense light of the third wavelength band to the third pixel 113. Then, the incident light is separated by the nano-photonic lens array 150 according to wavelengths and then condensed to the first to fourth pixels 111, 112, 113, and 114. To do this, the plurality of nano-structures NP may be arranged in different sizes and/or configurations in the first to fourth lenses 151, 152, 153, and 154 of the nano-photonic lens array 150. FIG. 6 shows that the nano-structures NP of respective lenses can have identical diameters, and can have the nano-structures NP of different diameters. Also, the nano-structures NP may be arranged in configurations over respective pixels. Because the incident light is color-separated by the nano-photonic lens array 150 to a considerable degree, the absorption loss may be low even when the color filter layer 120 is used. Also, color purity may be improved because the nano-photonic lens array 150 and the color filter layer 120 are used together.

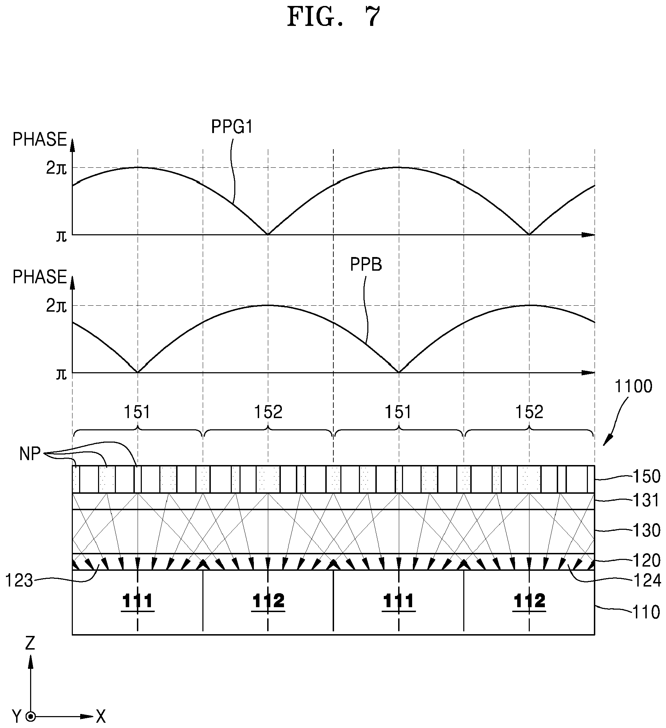

FIG. 7 is a diagram showing an example of a phase profile of green light and blue light after passing through the nano-photonic lens array 150 of FIG. 6. In FIG. 7, the etch-stop layer 140 and the anti-reflection layer 160, among other elements, are omitted for ease of discussion. Referring to FIG. 7, the green light after passing through the nano-photonic lens array 150 may have a first green light phase profile PPG1 that is largest at the center of the first lens 151 and decreases away from the center of the first lens 151. In detail, at a position immediately after passing through the nano-photonic lens array 150, that is, on the lower surface of the nano-photonic lens array 150 or the upper surface of the encapsulation layer 131, the phase of the green light is largest at the center of the first lens 151 and may decrease along a concentric circle away from the center of the first lens 151. When the phase of the green light emitted from the center of the first lens 151 is set as 2π, light having a phase of 0.9π to 1.1π may be emitted from the centers of the second and third lenses 152 and 153, light having a phase of 2π may be emitted from the center of the fourth lens 154, and light having a phase of 1.1π to 1.5π may be emitted from a contact point between the first and fourth lenses 151 and 154. Therefore, a difference between the phase of the green light that has passed through the center of the first lens 151 and the phase of the green light that has passed through the centers of the second and third lenses 152 and 153 may be about 0.9π to about 1.1π.

In addition, the first green light phase profile PPG1 does not denote that the phase delay amount of the light that has passed through the center of the first lens 151 is largest, but when the phase of light that has passed through the first lens 151 is set as 2π and a phase delay amount of the light that has passed through another point is greater and has a phase value of 2π or greater, the first green light phase profile PPG1 may denote a value remaining after subtracting 2nπ, that is, a wrapped phase profile. For example, when the phase of light that has passed through the first lens 151 is 2π and the phase of light that has passed through the center of the second lens 152 is 3π, the phase in the second lens 152 may be a remaining π after subtracting 2π (n=1) from 3π.

Also, the blue light that has passed through the nano-photonic lens array 150 may have a blue light phase profile PPB that is largest at the center of the second lens 152 and decreases away from the center of the second lens 152. In detail, at a position immediately after passing through the nano-photonic lens array 150, the phase of the blue light may be largest at the center of the second lens 152 and may decrease in a concentric circle away from the center of the second lens 152. For example, when the phase of blue light at the center of the second lens 152 is 2π, the phase at the centers of the first lens 151 and the fourth lens 154 may be about 0.9π to about 1.1π, and the phase at the center of the third lens 153 may be less than the phase at the centers of the first and fourth lenses 151 and 154, for example, about 0.5π to about 0.9π.

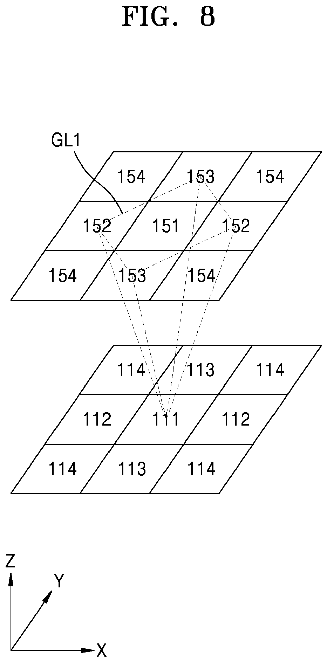

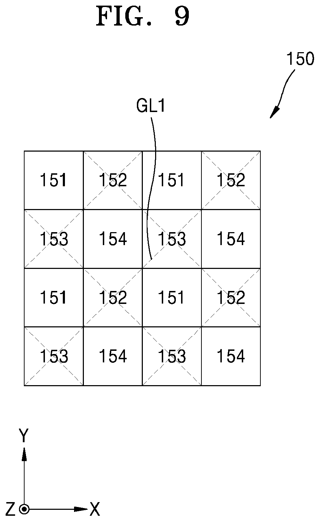

FIG. 8 shows an example of passage of green light that is incident on a periphery of a first lens 151 in the nano-photonic lens array 150, and FIG. 9 shows an example of an array of first green light condensing regions formed by the nano-photonic lens array 150.

Referring to FIG. 8, among the incident light incident on the first lens 151 and the incident light incident on a part of the second lens 152 and a part of the third lens 153, the green light is condensed to the first pixel 111 by the nano-photonic lens array 150. That is, according to the phase profile of the green light described above with reference to FIG. 7, the green light that has passed through a first green light condensing region GL1. The first green light condensing region GL1 is formed by connecting centers of two second lenses 152 with centers of adjacent two third lenses 153, and the lenses 152, 153 are adjacent to the first pixel 151. The light passing through the first green light condensing region GL1 is condensed onto the first pixel 111. Therefore, as shown in FIG. 9, the nano-photonic lens array 150 may operate as a first green light condensing region GL1 array for condensing the green light onto the first pixel 111. The first green light condensing region GL1 may have a greater area than that of the corresponding first pixel 111, e.g., may be 1.2 times to twice greater than that of the first pixel 111. The light condensed on the second green pixel 114 is analogously formed by other adjacent lens portions 152, 153.

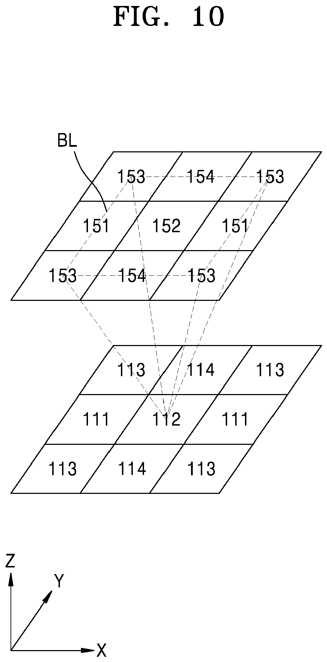

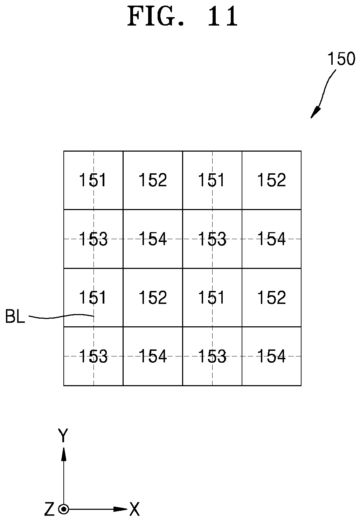

FIG. 10 shows an example of passage of blue light that is incident on a periphery of the second lens in the nano-photonic lens array 150, and FIG. 11 shows an example of an array of a blue light condensing region formed by the nano-photonic lens array 150.

Referring to FIG. 10, among the incident light incident on the second lens 152 and the incident light incident on a part of the first lens 151, a part of the third lens 153, and a part of the fourth lens 154, the blue light is condensed onto the second pixel 112 by the nano-photonic lens array 150. That is, according to the phase profile of the blue light described with reference to FIG. 7, the blue light that has passed through a blue light condensing region BL that is obtained by connecting the centers of four third lenses 153 that are adjacent to the second lens 152 at apexes onto the second pixel 112. Therefore, as shown in FIG. 11, the nano-photonic lens array 150 may operate as a blue light condensing region BL array for condensing the blue light to the second pixel 112. The blue light condensing region BL has an area greater than that of the second pixel 112, e.g., may be 1.5 to 4 times greater. The blue light condensing region BL may partially overlap a part of the first green light condensing region GL1, a part of a second green light condensing region GL2 that will be described later, and a part of a red light condensing region RL that will be described later.

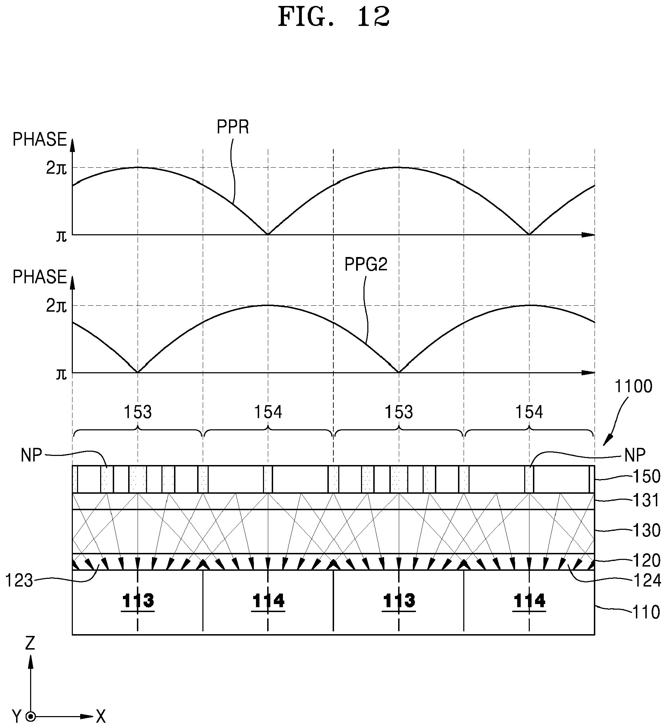

FIG. 12 is a diagram showing an example of a phase profile of red light and green light after passing through the nano-photonic lens array 150 of FIG. 6. In FIG. 12, the etch-stop layer 140 and the anti-reflection layer 160 are omitted to facilitate the description. Referring to FIG. 12, the red light after passing through the nano-photonic lens array 150 may have a red light phase profile PPR that is largest at the center of the third lens 153 and decreases away from the center of the third lens 153. In detail, at a position immediately after passing through the nano-photonic lens array 150, the phase of the red light may be largest at the center of the third lens 153 and may decrease in a concentric circle away from the center of the third lens 153. When the phase of red light at the center of the third lens 153 is 2π, the phase at the centers of the first lens 151 and the fourth lens 154 may be about 0.9π to about 1.1π, and the phase at the center of the second lens 152 may be less than the phase at the centers of the first and fourth lenses 151 and 154, for example, about 0.5π to about 0.9π.

Also, the green light that has passed through the nano-photonic lens array 150 may have a second green light phase profile PPG2 that is largest at the center of the fourth lens 154 and decreases away from the center of the fourth lens 154. Except that the second green light phase profile PPG2 has the largest phase at the center of the fourth lens 154, the descriptions about the first green light phase profile PPG1 may be also applied to the second green light phase profile PPG2.

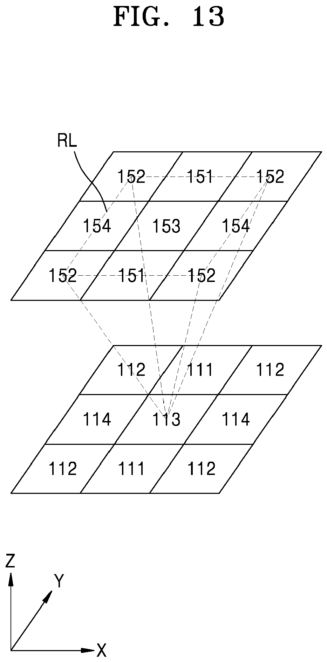

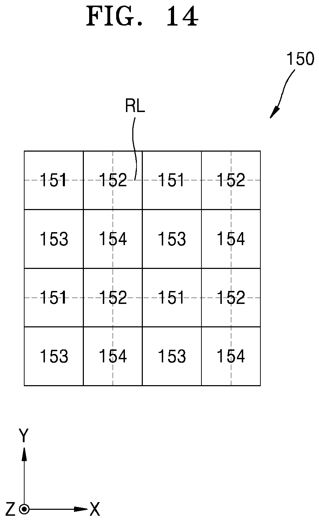

FIG. 13 shows an example of passage of red light that is incident on a periphery of the third lens in the nano-photonic lens array 150, and FIG. 14 shows an example of an array of a red light condensing region RL formed by the nano-photonic lens array 150.

Referring to FIG. 13, among the incident light incident on the third lens 153 and the incident light incident on a part of the first lens 151, a part of the second lens 152, and a part of the fourth lens 154, the red light is condensed onto the third pixel 113 by the nano-photonic lens array 150. That is, according to the phase profile of the blue light described with reference to FIG. 12, the red light that has passed through a red light condensing region RL that is obtained by connecting the centers of four second lenses 152 that are adjacent to the third lens 153 at apexes onto the third pixel 113. Therefore, as shown in FIG. 14, the nano-photonic lens array 150 may operate as a red light condensing region RL array for condensing the red light to the third pixel 113. The red light condensing region RL has an area greater than that of the third pixel 113, e.g., may be 1.5 to 4 times greater. The red light condensing region RL may partially overlap a part of the first green light condensing region GL1, a part of the blue light condensing region BL, and a part of a second blue light condensing region GL2 that will be described later.

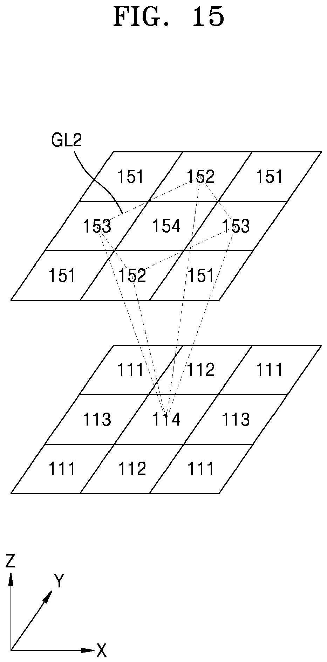

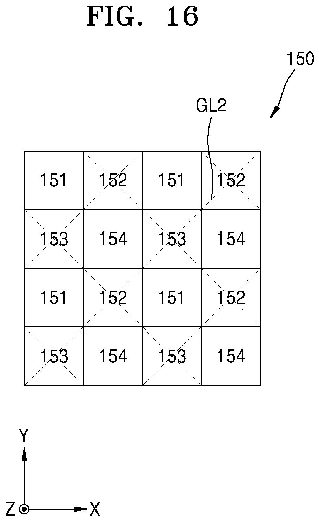

FIG. 15 shows an example of passage of green light that is incident on a periphery of the fourth lens in the nano-photonic lens array 150, and FIG. 16 shows an example of an array of a second green light condensing region formed by the nano-photonic lens array 150.

Referring to FIG. 15, in the incident light incident on the fourth lens 154 and the incident light incident on a part of the second lens 152 and a part of the third lens 153, the green light is condensed to the fourth pixel 114 by the nano-photonic lens array 150. That is, according to the phase profile of the green light described above with reference to FIG. 12, the green light that has passed through the second green light condensing region GL2 that is obtained by connecting centers of two second lenses 152 with centers of two third lenses 153 that are adjacent to the fourth pixel 154. The lenses 152 and 153contact adjacent sides of lens 154 to condense light onto the fourth pixel 114. Therefore, as shown in FIG. 16, the nano-photonic lens array 150 may operate as a second green light condensing region GL2 array for condensing the green light onto the fourth pixel 114. The second green light condensing region GL2 may have a greater area than that of the corresponding fourth pixel 114, e.g., may be 1.2 times to two times greater. The second green light condensing region GL2 may partially overlap a part of the first green light condensing region GL1, a part of the blue light condensing region BL, and a part of the red light condensing region RL.

Because the nano-photonic lens array 150 described above may separate the incident light by wavelengths and condense the separated light without absorbing or blocking the incident light, the light utilization efficiency of an image sensor 1000 may be improved.

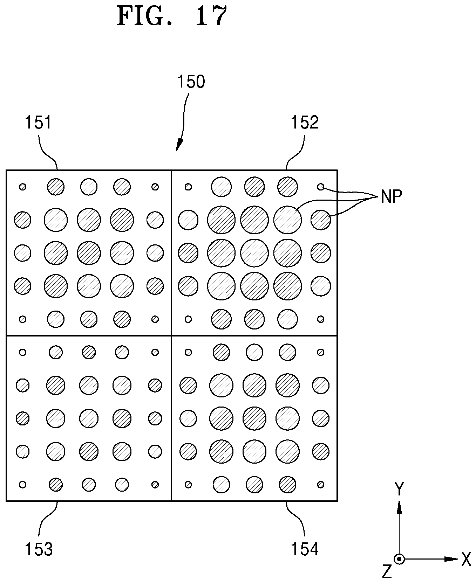

FIG. 17 is a plan view showing examples of arrangements of nano-structures NP in the nano-photonic lens array 150 according to another example embodiment in detail. In another example, the nano-photonic lens array 150 may condense the incident light to the first to fourth pixels 111, 112, 113, and 114 without prior color separation. Referring to FIG. 17, the plurality of nano-structures NP in each of the first to fourth lenses 151, 152, 153, and 154 may be arranged symmetrically with respect to the center of each of the first to fourth lenses 151, 152, 153, and 154 in the first direction (X-direction) and the second direction (Y-direction). In particular, the nano-structure NP arranged at the center of each of the first to fourth lenses 151, 152, 153, and 154 may have the largest diameter so that the largest phase delay may occur at the central region in each of the first to fourth lenses 151, 152, 153, and 154, and then, the diameters of the nano-structures NP may gradually decrease away from the center of each of the first to fourth lenses 151, 152, 153, and 154. For example, the nano-structures NP arranged at four apexes in each of the first to fourth lenses 151, 152, 153, and 154 may have the smallest diameters.

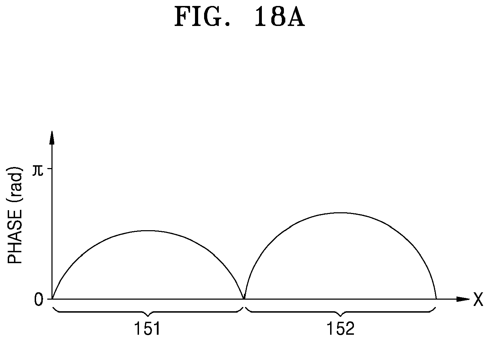

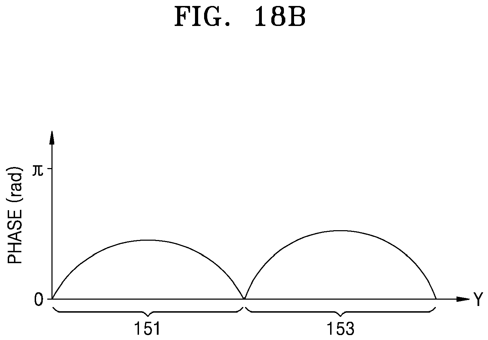

FIGS. 18A and 18B are diagrams showing an example of a phase profile of red light and green light after passing through the nano-photonic lens array 150 of FIG. 17. In particular, FIG. 18A shows the phase profile of light immediately after passing through the centers of the first and second lenses 151 and 152 in the first direction (X-direction), and FIG. 18B shows the phase profile of light immediately after passing through the first and third lenses 151 and 153 in the second direction (Y-direction).

Referring to FIG. 18A, the light immediately after passing through the first lens 151 may have the phase profile that is the largest at the center of the first lens 151 and decreases away from the center of the first lens 151 in the first direction (X-direction). The light immediately after passing through the second lens 152 has a phase profile that is largest at the center of the second lens 152 and decreases away from the center of the second lens 152 in the first direction (X-direction). Referring to FIG. 18B, the light immediately after passing through the first lens 151 may have the phase profile that is largest at the center of the first lens 151 and decreases away from the center of the first lens 151 in the second direction (Y-direction). The light immediately after passing through the third lens 153 has a phase profile that is largest at the center of the third lens 153 and decreases away from the center of the third lens 153 in the second direction (Y-direction).

Therefore, the light immediately after passing through the first lens 151 may have a phase profile that is formed as a convex curve that is symmetrical both in the first direction (X-direction) and the second direction (Y-direction). In FIGS. 18A and 18B, the light immediately after passing through each of the second to fourth lenses 152, 153, and 154 may have a phase profile that is formed as a convex curve in the first direction (X-direction) and the second direction (Y-direction). Then, the first lens 151 may condense the incident light to the first pixel 111 corresponding thereto, the second lens 152 may condense the incident light to the second pixel 112 corresponding thereto, the third lens 153 may condense the incident light to the third pixel 113 corresponding thereto, and the fourth lens 154 may condense the incident light to the fourth pixel 114 corresponding thereto.

Referring back to FIG. 3A, the color filter layer 120, the planarization layer 130, and the encapsulation layer 131 may also function as a spacer that provides a distance between the sensor substrate 110 and the nano-photonic lens array 150 so that the light that has passed through the nano-photonic lens array 150 may be focused on the sensor substrate 110. The distance between the sensor substrate 110 and the nano-photonic lens array 150 may be determined according to a focal length of the nano-photonic lens array 150. In particular, a sum T of a thickness Ta of the color filter layer 120, a thickness Tb of the planarization layer 130, and a thickness Tc of the encapsulation layer 131 may be similar to the focal length of the nano-photonic lens array 150. For example, a difference between the sum T of the thickness Ta of the color filter layer 120, the thickness Tb of the planarization layer 130, and the thickness Tc of the encapsulation layer 131 and the focal length of the nano-photonic lens array 150 may be within a range of ±20% of the focal length of the nano-photonic lens array 150.

The color filter layer 120 is required to have an optimal thickness range for appropriately absorbing the light according to a target transmission spectrum, and thus, the thickness Ta of the color filter layer 120 may be constant without regard to the focal length of the nano-photonic lens array 150. The encapsulation layer 131 may have a thickness by which the planarization layer 130 is protected and diffusion of the material in the color filter layer 120 is prevented. Therefore, the planarization layer 130 may mainly function as the spacer, and the thickness Tb of the planarization layer 130 may be determined according to the focal length of the nano-photonic lens array 150.

For example, the thickness Ta of the color filter layer 120 may be about 100 nm to about 800 nm. The thickness Tb of the planarization layer 130 may be determined within a range of about 300 nm to about 5 µm according to the focal length of the nano-photonic lens array 150. The thickness Tc of the encapsulation layer 131 may be less than the thickness Tb of the planarization layer 130. For example, the thickness Tc of the encapsulation layer 131 may be about 100 nm to about 500 nm. Also, a thickness Td of the nano-photonic lens array 150 may be about 500 nm to about 1500 nm. When the nano-photonic lens array 150 performs the function of a color separating lens described above with reference to FIGS. 6 to 16, a sum T1 of the thickness Tb of the planarization layer 130 and the thickness Tc of the encapsulation layer 131 may be equal to or greater than the thickness Td of the nano-photonic lens array 150 so as to secure the focal length of the nano-photonic lens array 150 and the distance for sufficiently separating colors and support the nano-photonic lens array 150. Alternatively, when the nano-photonic lens array 150 only performs the function of a lens described above with reference to FIGS. 17, 18A, and 18B, the focal length of the nano-photonic lens array 150 may be reduced. In this case, the sum T1 of the thickness Tb of the planarization layer 130 and the thickness Tc of the encapsulation layer 131 may be less than the thickness Td of the nano-photonic lens array 150.

In addition, referring to FIG. 3A, the etch stop layer 140 arranged between the encapsulation layer 131 and the nano-photonic lens array 150 may protect lower layers during an etching process for forming the nano-photonic lens array 150. The etch stop layer 140 may include a high-refractive index material that is not easy to be etched as compared with the encapsulation layer 131 located thereunder and is transparent with respect to visible light. The etch stop layer 140 may include, for example, a material, such as Al₂O₃, HfO₂, etc. The thickness of the etch stop layer 140 may be about 5 nm to about 50 nm.

Also, the anti-reflection layer 160 arranged on the light-incident surface of the nano-photonic lens array 150 may reduce the light, in the incident light, reflected by the upper surface of the nano-photonic lens array 150 and may improve the light utilization efficiency of the image sensor 1000. The anti-reflection layer 160 may include a material having a refractive index different from that of the material of the nano-structures NP in the nano-photonic lens array 150. In particular, an average refractive index of the anti-reflection layer 160 may be greater than a refractive index of air and may be less than an average refractive index of the nano-photonic lens array 150. For example, the anti-reflection layer 160 may include one layer formed of one material of SiO₂, Si₃N₄, and Al₂O₃. The anti-reflection layer 160 may be formed of a thickness of about 80 nm to about 120 nm. Alternatively, the anti-reflection layer 160 may have a multi-layered structure in which different dielectric materials are alternately stacked. For example, the anti-reflection layer 160 may be formed by alternately stacking two or three of SiO₂, Si₃N₄, and Al₂O₃. Alternatively, the anti-reflection layer 160 may include various patterns for anti-reflection.

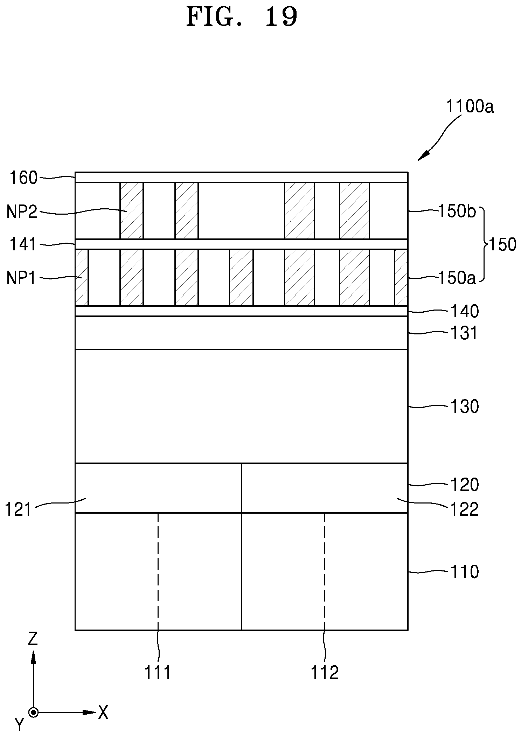

FIG. 19 is a cross-sectional view schematically showing a structure of a pixel array 1100a in an image sensor according to another embodiment. Referring to FIG. 19, the nano-photonic lens array 150 of the pixel array 1100a may have a multi-layered structure. For example, the nano-photonic lens array 150 may include a first nano-photonic lens array 150a arranged on the encapsulation layer 131, and a second nano-photonic lens array 150b arranged on the first nano-photonic lens array 150a. The first nano-photonic lens array 150a may include a plurality of first nano-structures NP1, and the second nano-photonic lens array 150b may include a plurality of second nano-structures NP2. Arrangement of the first nano-structures NP1 in the first nano-photonic lens array 150a and arrangement of the second nano-structures NP2 in the second nano-photonic lens array 150b may be the same as or different from each other. The nano-photonic lens array 150 may be easily manufactured when the nano-structures NP are separately formed as the first nano-structures NP1 and the second nano-structures NP2, rather than forming the nano-structures NP as one layer having a large aspect ratio. Also, in order to improve the efficiency of the nano-photonic lens array 150, the arrangement of the first nano-structures NP1 in the first nano-photonic lens array 150a and the arrangement of the second nano-structures NP2 in the second nano-photonic lens array 150b may be designed to be different from each other.

Also, the pixel array 1100a may further include an etch stop layer 141 additionally arranged between the first nano-photonic lens array 150a and the second nano-photonic lens array 150b. In this case, the etch stop layer 140 arranged between the encapsulation layer 131 and the first nano-photonic lens array 150a may be a first etch stop layer, and the etch stop layer 141 arranged between the first nano-photonic lens array 150a and the second nano-photonic lens array 150b may be a second etch stop layer.

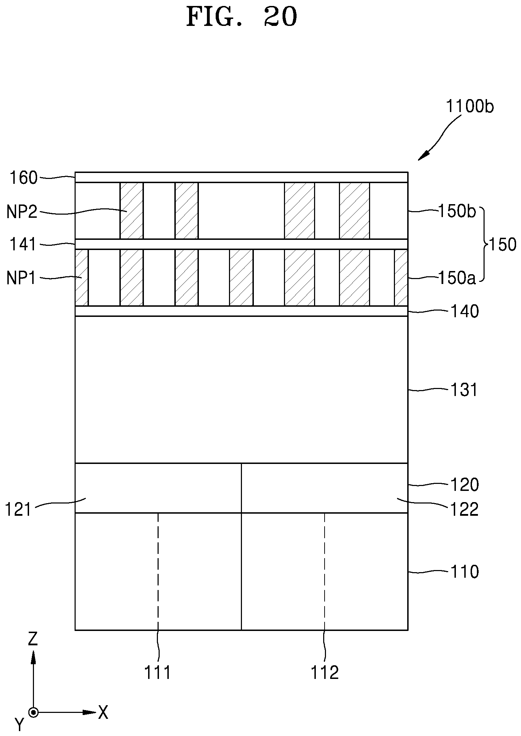

FIG. 20 is a cross-sectional view schematically showing a structure of a pixel array 1100b in an image sensor according to another embodiment. Referring to FIG. 20, the pixel array 1100b may only include the encapsulation layer 131 without the planarization layer between the color filter layer 120 and the nano-photonic lens array 150. In this case, a lower surface of the encapsulation layer 131 may be in direct contact with the color filter layer 120. The encapsulation layer 131 may only include an inorganic material such as SiO₂, SiN, SiON, etc. When the encapsulation layer 131 is directly formed on the color filter layer 120, a chemical mechanical polishing (CMP) process may be further executed in order to planarize an upper surface of the encapsulation layer 131 before forming the nano-photonic lens array 150. Also, when there is no planarization layer, the encapsulation layer 131 may have a thickness of about 100 nm to about 3 µm.

The image sensor 1000 may have an improved light utilization efficiency. As the light utilization efficiency is improved, a size of one pixel or size of independent photosensitive cells in the pixel of the image sensor 1000 may be reduced. Therefore, the image sensor 1000 having high resolution may be provided. The image sensor 1000 according to the embodiment may form a camera module along with a module lens of various functions and may be utilized in various electronic devices.

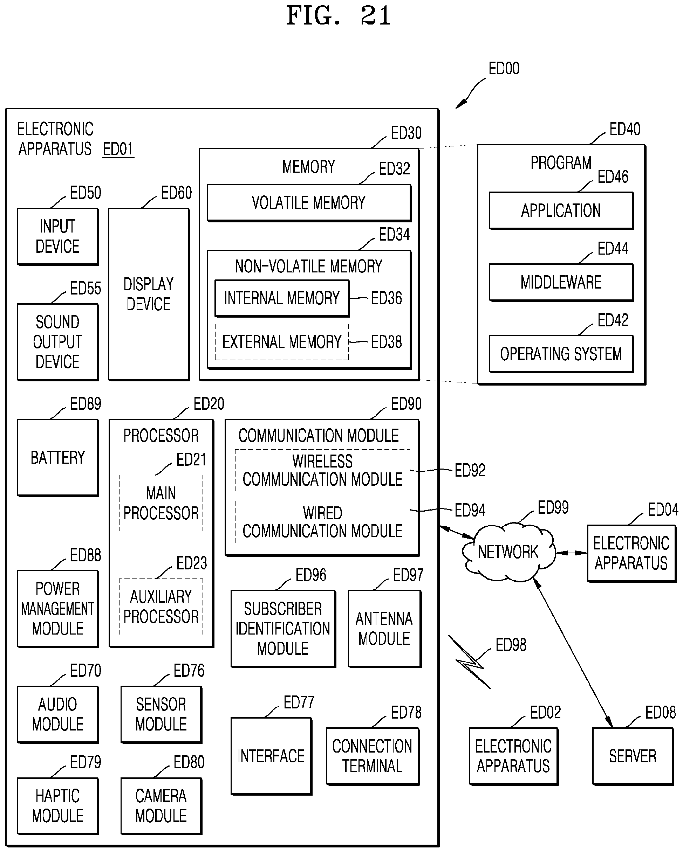

FIG. 21 is a block diagram showing an example of an electronic apparatus ED01 including an image sensor 1000. Referring to FIG. 21, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.)

The processor ED20 may control one or more elements (hardware, software elements, etc.) of the electronic apparatus ED01 connected to the processor ED20 by executing software (program ED40, etc.), and may perform various data processes or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The processor ED20 may include a main processor ED21 (central processing unit, application processor, etc.) and an auxiliary processor ED23 (graphic processing unit, image signal processor, sensor hub processor, communication processor, etc.) that may be operated independently from or along with the main processor ED21. The auxiliary processor ED23 may use less power than that of the main processor ED21, and may perform specified functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (display device ED60, sensor module ED76, communication module ED90, etc.) of the elements in the electronic apparatus ED01. The auxiliary processor ED23 (image signal processor, communication processor, etc.) may be implemented as a part of another element (camera module ED80, communication module ED90, etc.) that is functionally related thereto.

The memory ED30 may store various data required by the elements (processor ED20, sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (processor ED20, etc.) of the electronic apparatus ED01, from outside (user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (electronic apparatus ED02, electronic apparatus ED04, server ED08, etc.), and execution of communication through the established communication channel. The communication module ED90 may be operated independently from the processor ED20 (application processor, etc.), and may include one or more communication processors that support the direct communication and/or the wireless communication. The communication module ED90 may include a wireless communication module ED92 (cellular communication module, a short-range wireless communication module, a global navigation satellite system (GNSS) communication module) and/or a wired communication module ED94 (local area network (LAN) communication module, a power line communication module, etc.). From among the communication modules, a corresponding communication module may communicate with another electronic apparatus via a first network ED09 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

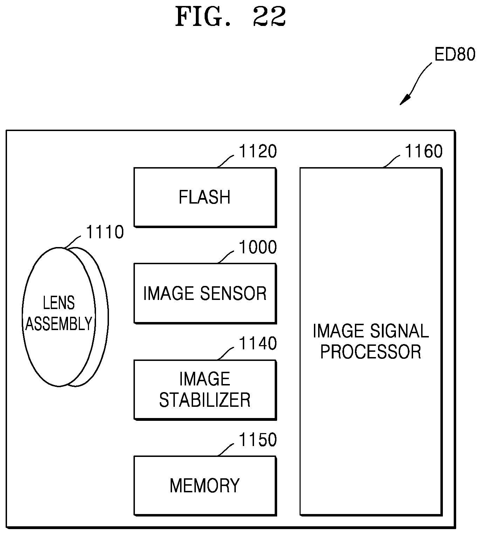

FIG. 22 is a block diagram showing an example of the camera module ED80 included in the electronic apparatus ED01 of FIG. 21. Referring to FIG. 22, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal distance, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus 1101 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor arranged in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high resolution data, etc.) is stored in the memory 1150, and a low resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image treatment by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 so that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 22, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

While the image sensor including the nano-photonic lens array and the electronic apparats including the image sensor have been particularly shown and described with reference to example embodiments thereof, it will be understood by those of ordinary skill in the art that various changes in form and details may be made therein without departing from the scope as defined by the following claims. The preferred embodiments should be considered in descriptive sense only and not for purposes of limitation. Therefore, the scope of the disclosure is defined not by the detailed description of the disclosure but by the appended claims, and all differences within the scope will be construed as being included in the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. An image sensor comprising:
a sensor substrate including a plurality of first pixels for sensing light of a first wavelength band and a plurality of second pixels for sensing light of a second wavelength band that is different from the first wavelength band;
a color filter layer on the sensor substrate, the color filter layer including a plurality of color filters;
an encapsulation layer arranged on the color filter layer; and
a nano-photonic lens array arranged on the encapsulation layer, the nano-photonic lens array including a plurality of nano-structures that are arranged to condense light of the first wavelength band, among incident light incident on the nano-photonic lens array, onto the plurality of first pixels and condense light of the second wavelength band, among the incident light, onto the plurality of second pixels.

2. The image sensor of claim 1, further comprising
a planarization layer arranged between the color filter layer and the encapsulation layer.

3. The image sensor of claim 2, wherein
the plurality of color filters in the color filter layer include organic color filters including an organic dye or an organic pigment.

4. The image sensor of claim 2 or 3, wherein
the planarization layer includes an organic polymer material.

5. The image sensor of claim 4, wherein
the organic polymer material includes at least one from an epoxy resin, polyimide, polycarbonate, polyacrylate, and polymethyl methacrylate.

6. The image sensor of any one of claims 2 to 5, wherein
a difference between a refractive index of the planarization layer and a refractive index of the encapsulation layer is within ±20% of the refractive index of the planarization layer.

7. The image sensor of any one of claims 2 to 6, wherein
a thickness of the encapsulation layer is less than a thickness of the planarization layer.

8. The image sensor of claim 7, wherein
a thickness of the encapsulation layer is 100 nm to 500 nm, and
the planarization layer has a thickness of 300 nm to 5 µm.

9. The image sensor of any one of claims 2 to 8, wherein
a difference between a sum of a thickness of the color filter layer, a thickness of the planarization layer, and a thickness of the encapsulation layer and a focal length of the nano-photonic lens array is within ±20% of the focal length of the nano-photonic lens array.

10. The image sensor of any one of claims 2 to 9, wherein
a sum of a thickness of the planarization layer and a thickness of the encapsulation layer is equal to or greater than a thickness of the nano-photonic lens array.

11. The image sensor of any preceding claim, wherein
the encapsulation layer includes an inorganic material including at least one from SiO₂, SiN, and SiON.

12. The image sensor of any preceding claim, wherein
each of the plurality of first pixels and second pixels comprises:
a plurality of photosensitive cells that are two-dimensionally arranged and grouped in a first direction and a second direction and independently sense light, the second direction being perpendicular to the first direction; and
an isolation electrically isolating the plurality of photosensitive cells.

13. The image sensor of any preceding claim, further comprising
an etch stop layer arranged between the encapsulation layer and the nano-photonic lens array.

14. The image sensor of any preceding claim, wherein the nano-photonic lens array includes a first pattern of nano structures corresponding to a respective first pixel of the plurality of first pixels, and a second pattern of nano structures corresponding to a respective second pixel of the plurality of second pixels, wherein the first pattern of nano structures and the second pattern of nano structures are disposed next to each other, and wherein the first pattern of nano structures and the second pattern of nano structures condense the incident light onto the respective first pixel of the plurality of pixels.

15. An electronic apparatus comprising:
a lens assembly for forming an optical image of a subject;
an image sensor according to any preceding claim for converting the optical image formed by the lens assembly into an electrical signal; and
a processor configured to process a signal generated by the image sensor.
